Europäisches Patentamt

European Patent Office

Office européen des brevets

(19)

(11) Veröffentlichungsnummer: **0 149 804**
A2

(12) **EUROPÄISCHE PATENTANMELDUNG**

(21) Anmeldenummer: **84115593.0**

(22) Anmeldetag: **17.12.84**

(51) Int. Cl.⁴: **H 04 N 7/13**

(30) Priorität: **12.01.84 DE 3400919**

(43) Veröffentlichungstag der Anmeldung:
**31.07.85 Patentblatt 85/31**

(84) Benannte Vertragsstaaten:
**AT BE CH DE FR GB IT LI NL SE**

(71) Anmelder: **Siemens Aktiengesellschaft**
**Berlin und München Wittelsbacherplatz 2**
**D-8000 München 2(DE)**

(72) Erfinder: **Strehl, Herbert, Dipl.-Ing.**
**Drozzaweg 15**
**D-8000 München 70(DE)**

(54) Verfahren zur Feststellung der genauen Fehlerbündellänge.

(57) Verfahren zur Feststellung der genauen Fehlerbündellänge bei der durch einen fehlerkorrigierenden Blockcode
gesicherten Übertragung von Bildsignalen, bei dem
empfangsseitig die korrigierten Bits mit entsprechend verzögerten unkorrigierten Bits verglichen werden und die bei
Nichtübereinstimmung erzeugten Fehlersignale ausgewertet
werden.

FIG 1

Croydon Printing Company Ltd.

Siemens Aktiengesellschaft
Berlin und München

Unser Zeichen
VPA 84 P 1014 E

Verfahren zur Feststellung der genauen Fehlerbündellänge

Die Erfindung betrifft ein Verfahren zur Feststellung der genauen Fehlerbündellänge bei einer durch einen fehlerkorrigierenden Blockcode gesicherten Datenübertragung, insbesondere von Bildsignalen.

Bei der digitalen Übertragung von Fernsehsignalen wird häufig zur Bandbreitenreduktion das Differenzpulscodemodulations-Verfahren angewendet. Nachteilig bei diesem Verfahren ist es, daß bereits die Verfälschung eines oder weniger Bits auf der Übertragungsstrecke sich deutlich als Fehlerschleppe auf dem empfangenen Fernsehbild bemerkbar machen. Bei den Störungen auf der Übertragungsstrecke handelt es sich im allgemeinen um Bündelstörungen mit einer Fehlerrate kleiner $1 \times 10^{-6}$. Die Datensicherung erfolgt im allgemeinen durch Blockcodes, wobei jedoch nur wenige Sicherungsbits zur Verfügung stehen. Für die reine Burstkorrektur eignet sich beispielsweise der Fire-Code; es können jedoch auch zusätzliche Einzelfehler korrigierende Codes, z.B. ein BCH-Code, verwendet werden.

Die Überschreitung der Korrekturfähigkeit kann nicht immer aufgrund der Codestruktur festgestellt werden. In vielen Fällen werden bei Überschreitung der Korrekturfähigkeit zusätzliche Bits gefälscht. Bei der Übertragung von Bildsignalen wird, wenn eine Überschreitung der Korrekturfähigkeit erkennbar ist, auf eine sogenannte Bildfehlerverdeckung umgeschaltet. In diesem Fall werden nicht die übertragenen Signalwerte weiterverarbeitet, sondern es werden die entsprechenden Signalwerte des letzten Fernsehbildes verwendet oder die Signalwerte werden aus den benachbarten Signalwerten desselben Fernsehbildes errechnet.

P 1 Seu / 20.12.83

0149804

Häufig werden integrierte Bausteine mit kompletten Codierern und Decodierern verwendet. Signalausgänge, die anzeigen, welches Bit korrigiert wird, fehlen in der Regel.

Aufgabe der Erfindung ist es, ein einfaches Verfahren zur Feststellung der genauen Fehlerbündellänge anzugeben.

Ausgehend vom einleitend beschriebenen Stand der Technik wird diese Aufgabe dadurch gelöst, daß die empfangenen unkorrigierten Bits mit den entsprechenden korrigierten Bits verglichen werden und daß bei Nichtübereinstimmung zweier entsprechender Bits ein Fehlersignal abgegeben wird.

Durch dieses Verfahren werden alle korrigierten Bits erfaßt. Im allgemeinen sind nur die Informationsbits von Interesse; für statistische Zwecke können jedoch ebenso die Sicherungsbits mitberücksichtigt werden. Die durch den Vergleich von korrigierten und nicht korrigierten Bits erhaltenen Fehlersignale können selbstverständlich mit codeeigenen Kriterien, z.B. nicht korrigierbares Fehlerbündel, kombiniert werden.

Es ist vorteilhaft, daß mehrere Codeblöcke entsprechend der Fehlerbündelkorrekturfähigkeit bitgruppenweise zu einem Multiplex-Codeblock miteinander verschachtelt werden, daß empfangsseitig die Fehlerkorrektur in mehreren parallelen Decodiereinrichtungen erfolgt und daß die von den Decodiereinrichtungen abgegebenen Fehlersignale über eine ODER-Schaltung zusammengefaßt werden.

Durch die Verschachtelung von Codeblöcken können bei relativ kurzen Codeblöcken lange Fehlerbündel korrigiert werden. Die Codierer und Decodierer sind entsprechend einfach aufgebaut. Die Fehler werden für jeden Codeblock einzeln ermittelt; durch die ODER-Schaltung erhält man die genaue Fehlerstruktur auf der Übertragungsstrecke - gegebenenfalls unter Berücksichtigung der Sicherungsbits.
Die Ermittlung der Fehlerbündellänge kann stets in Betrieb erfolgen, ein spezieller Prüftext ist nicht erforderlich.

Es ist zweckmäßig, daß die Fehlersignale jeweils innerhalb eines Codeblockes gezählt werden.

Im allgemeinen reicht die Ermittlung der Fehleranzahl pro Codeblock aus.

Weitere vorteilhafte Ausbildungen der Erfindung sind in den übrigen Unteransprüchen angegeben.

Das erfindungsgemäße Verfahren wird anhand von drei Figuren näher erläutert.

Es zeigen

Fig. 1  ein Prinzipschaltbild zur Ermittlung der Fehlerbündellänge in einem Codierungskanal,

Fig. 2  einen Multiplex-Codeblock und

Fig. 3  eine Schaltungsanordnung zur Ermittlung der Fehlerbündellänge bei mehreren ineinander verschachtelten Codeblöcken.

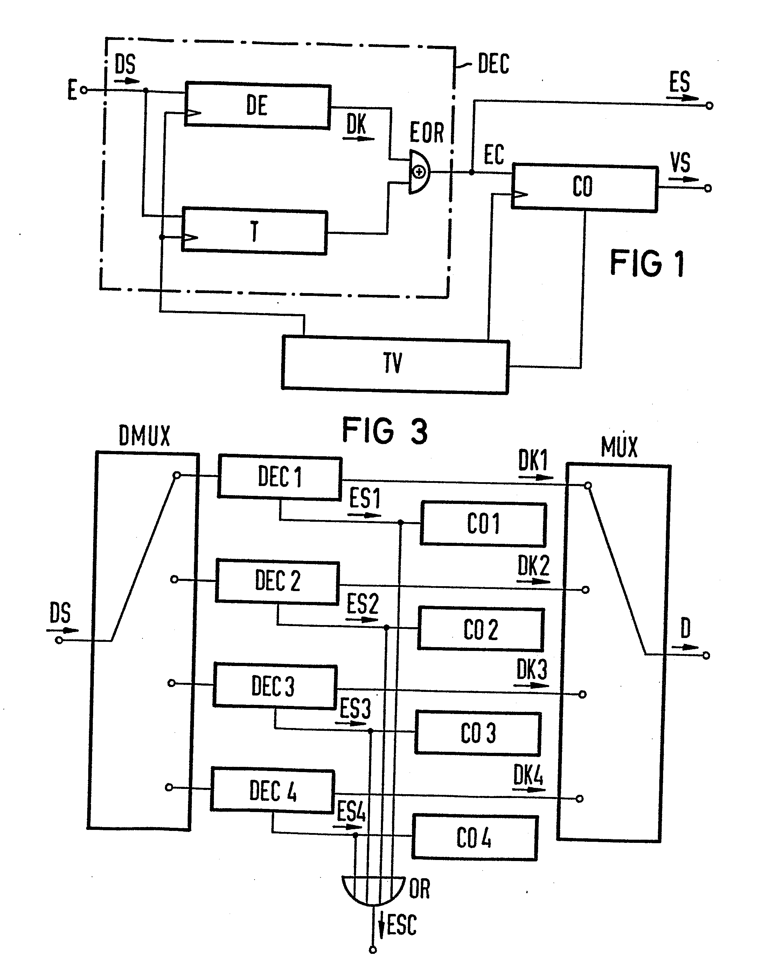

In Fig. 1 ist ein Prinzipschaltbild zum Messen der Fehlerbündellänge dargestellt. Über einen Eingang E wird dem Decodierer DE das gesicherte Digitalsignal DS zugeführt. Dieses Signal wird über ein Laufzeitglied T mit derselben Laufzeit,wie der Decodierer DE aufweist, geführt. Der Ausgang des Decodierers und der Ausgang des Laufzeitgliedes sind mit den Eingängen eines Exklusiv-ODER-Gatters EOR verbunden. Am Ausgang des Exklusiv-ODER-Gatters wird ein Fehlersignal ES abgegeben. Der Ausgang des Exklusiv-ODER-Gatters EOR ist mit dem Zählereingang EC eines Binärzählers CO verbunden. Eine Taktversorgung TV liefert die notwendigen Arbeitstakte und stellt den Binärzähler am Ende jedes Codeblockes zurück.

Hier wird zunächst angenommen, daß sowohl die korrigierten Datenbits als auch die korrigierten Sicherungsbits vom Decodierer DE abgegeben werden. Dieses korrigierte Digitalsignal DK wird mit dem direkt empfangenen unkorrigierten Digitalsignal DS bitweise verglichen. Stimmen zwei Bits am Eingang des Exklusiv-ODER-Gatters EOR nicht überein, so wird ein Fehlersignal ES abgegeben. Die Fehler werden in dem Binärzähler CO gezählt. Dessen Zählerstand kann am Ende eines jeden Codeblockes abgefragt werden; außerdem gibt der Zähler bei Überschreitung eines vorgegebenen Zählerstandes ein Störungssignal VS ab, das die Überschreitung der Korrekturfähigkeit anzeigt. Wegen der geringen Redundanz reicht es im allgemeinen aus, nur die korrigierten Datenbits am Ausgang des Decodierers mit den unkorrigierten Datenbits zu vergleichen.

Anstelle des bitweisen Vergleichs kann selbstverständlich ein Vergleich von Datenwörtern treten.

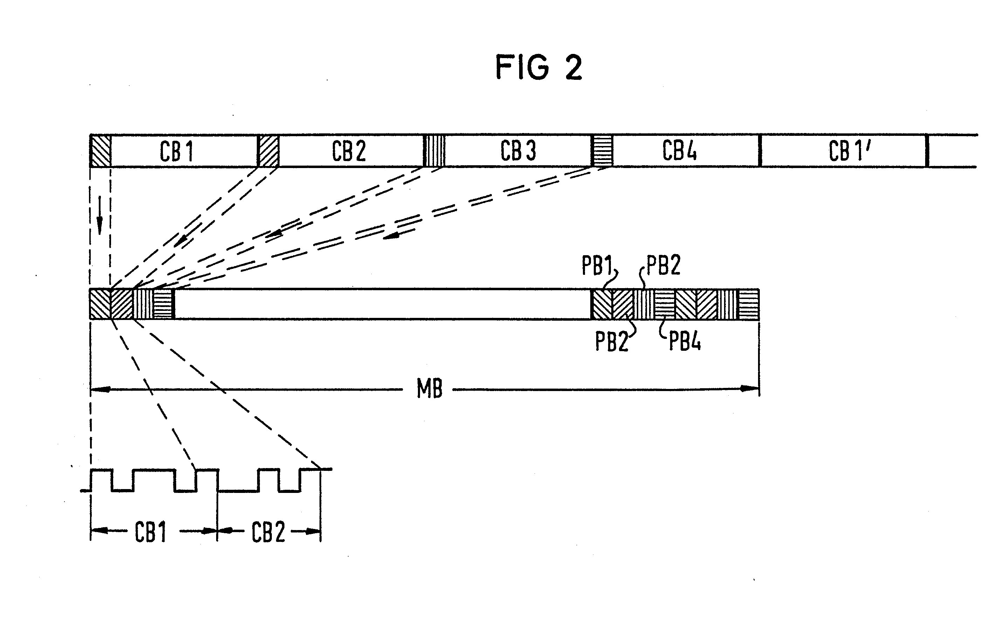

In Fig. 2 ist die Verschachtelung von vier Codeblöcken CB1 bis CB4 zu einem Multiplex-Codeblock MB dargestellt. Es wird jeweils eine hier fünf Bits umfassende Bitgruppe des ersten Codeblockes CB1 ausgesendet, dann folgen fünf Bits des zweiten Codeblockes CB2 usw. Am Ende des Multiplex-Codeblockes werden die Sicherungsbits PB1 bis PB4 ebenfalls verschachtelt übertragen. Die Anzahl der jeweils miteinander verschachtelten Bits entspricht der Korrekturfähigkeit.

In Fig. 3 ist ein Prinzipschaltbild zur Ermittlung der Fehlerbündellänge bei verschachtelten Blockcodes dargestellt. Das digitale Datensignal DS wird in Form eines Multiplex-Codeblockes empfangen und von einem Demultiplexer DMUX beispielsweise fünfbitweise auf vier Decodiereinrichtungen DEC1 bis DEC4 verteilt. Die Datenausgänge der Decodiereinrichtungen sind mit den Eingängen eines Multiplexers MUX verbunden, der die abgegebenen korrigierten Datensignale DK1 bis DK4 wieder zu dem ursprünglichen Datensignal D zusammenfaßt. Jede Decodiereinrichtung (DEC) enthält nach Fig. 1 einen Decodierer DE, ein Laufzeitglied T und ein Exklusiv-ODER-Gatter EOR. Der Fehlersignalausgang der Decodierer ist jeweils mit einem Binärzähler CO1 bis CO4 verbunden. Außerdem sind die Fehlerausgänge über eine ODER-Schaltung OR zusammengefaßt.

Zunächst wird angenommen, daß jeweils fünf Bits eines Codeblockes in einer Decodiereinrichtung bitgruppenweise verarbeitet werden.

Die Decodiereinrichtungen können natürlich auch bei gegeneinander versetzten Arbeitstakten und entsprechender Zwischenspeicherung der jeweiligen Bitgruppen kontinuierlich mit geringer Taktrate arbeiten. Die von den Decodiereinrichtungen abgegebenen Fehlersignale ES1 bis ES4 werden durch die ODER-Schaltung OR zu einem gemeinsamen Fehlersignal ESC zusammengefaßt, das der Fehlerstruktur auf der Übertragungsstrecke entspricht. Dieses Fehlersignal kann softwaremäßig nach statistischen Gesichtspunkten ausgewertet werden, ebenso ist eine exakte Aufzeichnung der Fehlerstruktur möglich. Darüber hinaus werden die Fehler jeweils innerhalb eines Codeblockes in den Binärzählern CO1 bis CO4 gezählt. Bei Überschreitung der Fehlerkorrekturfähigkeit geben diese Zähler wiederum ein Störungssignal ab, das die Umschaltung auf einen Fehlerverdeckungsalgorithmus bewirkt. Sind innerhalb eines Multiplexblockes von beispielsweise zwei oder drei Codeblöcken CB1 bis CB4 nur beispielsweise zwei oder drei Codeblöcke über ihre Korrekturfähigkeit hinaus gestört, so kann es zweckmäßig sein, den ganzen Multiplex-Codeblock - also auch die fehlerfreien Codeblöcke - zu ersetzen. Dies ist jedoch

0149804

abhängig von dem für das Digitalsignal verwendeten Codierungsverfahren. Für die Fehlerverdeckung sind zahlreiche Verfahren bekannt, die jedoch nicht Gegenstand dieser Erfindung sind.

Dieses Verfahren ermöglicht auf einfache Weise das Feststellen der Fehlerbündellänge und gegebenenfalls auch die Beurteilung der Übertragungsstrecke durch statistische Auswertung der Fehlerstrukturen.

6 Patentansprüche
3 Figuren

Patentansprüche

1. Verfahren zur Feststellung der genauen Fehlerbündellänge bei einer durch einen fehlerkorrigierenden Blockcode gesicherten Datenübertragung, insbesondere von Bildsignalen, d a d u r c h   g e k e n n z e i c h n e t , daß die empfangenen unkorrigierten Bits mit den entsprechenden korrigierten Bits (DK) verglichen werden und daß bei Nichtübereinstimmung zweier entsprechender Bits ein Fehlersignal (ES) abgegeben wird.

2. Verfahren nach Anspruch 1, d a d u r c h   g e k e n n z e i c h n e t , daß mehrere Codeblöcke (CB1 bis CB4) entsprechend der Fehlerbündelkorrekturfähigkeit bitgruppenweise zu einem Multiplex-Codeblock (MB) miteinander verschachtelt werden, daß empfangsseitig die Fehlerkorrektur in mehreren parallelen Decodiereinrichtungen (DEC1 bis DEC4) erfolgt und daß die von den Decodiereinrichtungen abgegebenen Fehlersignale (ES1 bis ES4) über eine ODER-Schaltung (OR) zusammengefaßt werden.

3. Verfahren nach Anspruch 1 oder 2, d a d u r c h   g e k e n n z e i c h n e t , daß die Fehlersignale (ES) jeweils innerhalb eines Codeblockes (CB1, CB2) gezählt werden.

4. Verfahren nach Anspruch 3, d a d u r c h   g e k e n n z e i c h n e t , daß die Zählung durch Binärzähler (CO, C01, C02...) erfolgt.

5. Verfahren nach einem der Ansprüche 1 bis 3, d a d u r c h   g e k e n n z e i c h n e t , daß die Auswertung der Fehlerstrukturen softwaremäßig erfolgt.

6. Verfahren nach einem der vorhergehenden Ansprüche, d a d u r c h   g e k e n n z e i c h n e t , daß ein Störungssignal abgegeben wird, wenn innerhalb eines Codeblockes die gezählten Bitfehler die Fehlerkorrekturfähigkeit überschreiten.

0149804

1/2

FIG 1

FIG 3

# FIG 2